Europäisches Patentamt

**European Patent Office**

Office européen des brevets

(19)

(11) Publication number: **0 109 183**
A2

(12) # EUROPEAN PATENT APPLICATION

(21) Application number: **83306173.2**

(51) Int. Cl.³: **G 03 F 5/20**, G 03 F 3/10

(22) Date of filing: **12.10.83**

(30) Priority: **14.10.82 GB 8229421**

(43) Date of publication of application: **23.05.84** Bulletin **84/21**

(84) Designated Contracting States: **AT BE CH DE FR GB IT LI NL SE**

(71) Applicant: **UNILEVER PLC, Unilever House Blackfriars P O Box 68, London EC4P 4BQ (GB)**

(84) Designated Contracting States: **GB**

(71) Applicant: **UNILEVER NV, Burgemeester s'Jacobplein 1 P.O. Box 760, NL-3000 DK Rotterdam (NL)**

(84) Designated Contracting States: **BE CH DE FR IT LI NL SE AT**

(72) Inventor: **Nissen, William, 7 Moss Bank Close Astley Bridge, Bolton Lancashire (GB)**

(74) Representative: **Rogers, John Edward et al, UNILEVER PLC Patents Division P.O. Box 68 Unilever House, London EC4P 4BQ (GB)**

(54) **Lithographic printing.**

(57) A lithographic printing member which can be used to simulate gravure printing for proof making has a discrete cell structure in the shadow end of the tonal range above 50%.

EP 0 109 183 A2

- 1 -     Z.416L

# LITHOGRAPHIC PRINTING

This invention relates to lithographic printing and particularly to a lithographic printing member and a method for the production thereof.

The lithographic printing method cannot print varying intensities of ink in order to reproduce a gradual tonal range.  Continuous tones are simulated by breaking up the planographic surface of the printing member to provide variations in the surface adsorption of moisture, the image being broken up into dots of varying surface areas by eg film contact screens.  The dots increase in size according to the density of tone and above the 50% stage, ie where the dots cover 50% or more of the area, the dots become linked and become completely solid at the 100% stage.

In the gravure inverted halftone printing method the printing member is formed with cells, ink applied to the surface filling the cells and the surplus wiped away with a doctor blade.  Not only can the area of the cells be varied to reproduce variations in tone but the depth of the cells can also be varied so that the various tones are seen as variations in the ink film thickness combined with imprinted areas of the substrate. The use of the doctor blade to wipe away surplus ink necessitates a discrete cell structure throughout the tonal range. A gravure process print can therefore be readily distinguished from a lithographic process print by examination of the dot structure above the 50% stage of the tonal range.

Where gravure process printing is to be employed it can be advantageous to be able to proof the work before incurring the expense of engraving the gravure plate or cylinder. Modifications to an engraved gravure printing member are difficult if not impossible to effect and are therefore to be avoided.

According to the present invention there is provided a lithographic printing member in which the tonal range of the subject at the shadow end of the range in which the dots are 50% or more of the area comprises a plurality of discrete dots. The production of a lithographic printing member is substantially cheaper than the production of a gravure printing member but by providing the dot structure of the gravure printing process the lithographic printing member can be used to give proofs with gravure printing characteristics. These proofs can be used to assess the work before an expensive gravure printing member is produced.

When a gravure roll is being engraved the engraver knows the minimum dot size required which can vary according to the nature of the substrate to be printed and other factors such as the machine being used for printing and the way in which it is set up and adjusted. If the user of the roll prints a minimum gravure dot size of 10% then the printed work will have a minimum dot size of about 12 of 13% because of the spread of ink from the cells producing the dot. Thus a lithographic proofing plate will be required having a dot size ranging between 12 or 13% in the highlight or lower tones to 100% at the shadow or upper tones. Since a lithographic plate produced with a lithographic screen normally has a dot size ranging from about 8% or less to 100% a minimum dot size of 12-13% produced with a lithographic screen results in a compression of the tonal scale giving an untrue appearance particularly in the shadow areas of the printed work which tends to have a flatter appearance.

Using a gravure screen to produce a lithographic printing plate largely avoids this flat appearance arising from a compression of the tonal range because even at the 100% level in the shadow area the dots are still discrete.

Thus the dot size throughout the tonal range can be increased in size to give a minimum dot size of the required value, about 12-13%, with the dots at the shadow end of the range remaining substantially discrete. Thus there is little or no compression of the tonal range. Preferably the dots at the 100% level have a narrow slightly discernible gap therebetween.

Preferably the lithographic printing member has at least 3,600 dots per $cm^2$, in order to more accurately simulate the gravure process.

The invention also provides a method of producing a lithographic printing member comprising producing a continuous tone photographic image of the subject to be

- 4 -                                         z.4161
                                      0109183

reproduced, and preparing a screened image for transfer to a lithographic printing member by exposing a film to the continuous tone through a gravure screen to reproduce the varying tones of the subject in a pattern of discrete dots, throughout the tonal range.   Were the film given only the normal exposure to produce a film for conversion to a gravure printing member the distance between the dots at the 100% stage, ie at the extreme shadow end of the tonal range, would be visibly greater than in the proof taken from the lithographic member in a gravure print. This would not simulate a gravure print in which the ink in the cells of the printing member would tend to merge across the grid pattern of the cells in the print at the 100% stage.   Preferably the film is exposed to provide discrete dots at the 100% shadow tone having narrow slightly discernible gaps therebetween in the screened image.   This more accurately simulates a gravure print.

The necessary exposure may be provided by simply over-exposing the film to the continuous tone through the screen but to close the dot wall on the film at the deepest shadow areas, ie the 100% stage, using a gravure screen may require an exposure of such duration that over-exposure would result in the middle tones and high-light areas, and the film would have shadow areas with plenty of detail but having a dot formation lacking density in the core of the dots.   To correct this a short auxiliary exposure can be made independent of the continuous tone but through the screen to produce a small dot all over the negative.

This additional exposure when given overcomes the 'inertia' of the emulsion, so that the low intensity of light reflected from the shadows of the original can be recorded, and builds up the minute dot formation already continuous tone through a gravure screen to reproduce the varying tones of the subject in a pattern of discrete dots, throughout the tonal range. Were the film given only the normal exposure to produce a film for conversion to a gravure printing member the distance between the dots at the 100% stage, ie at the extreme shadow end of the tonal range, would be visibly greater than in the proof taken from the lithographic member in a gravure print. This would not simulate a gravure print in which the ink in the cells of the printing member would tend to merge across the grid pattern of the cells in the print at the 100% stage. Preferably the film is exposed to provide discrete dots at the 100% shadow tone having narrow slightly discernible gaps therebetween in the screened image. This more accurately simulates a gravure print.

The necessary exposure may be provided by simply over-exposing the film to the continuous tone through the screen but to close the dot wall on the film at the deepest shadow areas, ie the 100% stage, using a gravure screen may require an exposure of such duration that over-exposure would result in the middle tones and high-light areas, and the film would have shadow areas with plenty of detail but having a dot formation lacking density in the core of the dots. To correct this a short auxiliary exposure can be made independent of the continuous tone but through the screen produces a small dot all over the negative.

This additional exposure when given overcomes the 'inertia' of the emulsion, so that the low intensity of light reflected from the shadows of the original can be recorded, and builds up the minute dot formation already started and minimises or reduces the exposure necessary through the continuous tone.

Z.416
0109183

Preferably the additional exposure without the continuous tone is made prior to the exposure with the continuous tone present. The exposure made with the continuous tone present can be made through a coloured filter to alter the contrast by opening the middle to upper tones so that a balanced tonal range is obtained in the final screened image.

If the desired dot size and tonal balance is not obtained by the above methods the film after developing can be placed over another unexposed film with a clear film spacer therebetween and given a general maximum exposure. The spacer spaces the emulsion on the developed film away from the unexposed film thus allowing a spread of light that increases the dot size in the shadows to an acceptable 95% for proofing whilst leaving the middle to lower tones with a balanced dot size separation.

For a better understanding of the present invention reference will now be made to the accompanying drawings showing on an enlarged scale the dot structure of different screened films each being shown at 100%, 75%, 50% and 25% stages with reference to the areas that the dot structure will print in which:

Figure 1 is a gravure screened film for producing a gravure printing member having cells of variable area and constant depth;

Figure 2 is a lithographic screened film; and

Figure 3 is a screened film according to the present invention.

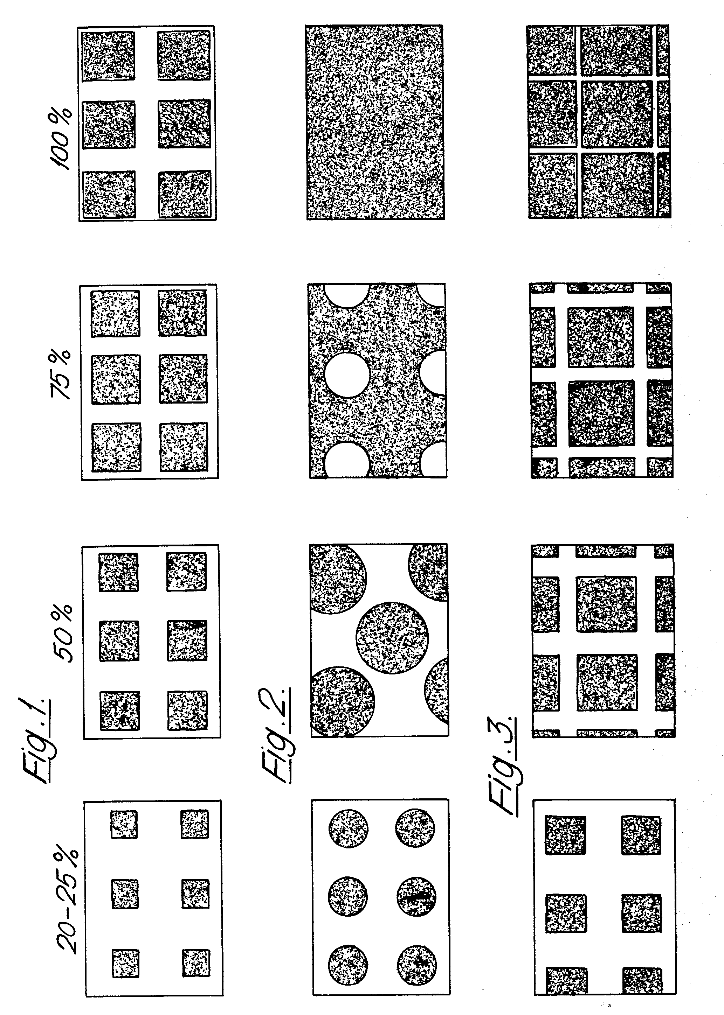

The screened films of Figure 1 have been produced using a gravure screen and it will be seen that at the 100% level, ie the dot structure which will print an overall layer of ink on the substrate, the cells are still discrete.  These discrete cells are necessary on a gravure printing member in order that the cell walls, the white areas, will support the doctor blade which wipes away surplus ink from the printing member and prevent the doctor blade removing ink from the cells.  · Because the cells have a depth there is sufficient ink transferred to the substrate to cover the substrate overall.  At all other stages the dot structure is discrete and the substrate is printed with dots slightly larger than the area of the cells.

The films of Figure 2 were produced using a lithographic screen to give an overall printing area at the 100% stage since the quantity of ink that can be printed is much more limited by the lithographic printing process.  At the 25% stage the dot structure is discrete but at the 50% stage and above they merge so that areas not to be printed appear as white areas.

It can therefore be appreciated that using a gravure screened film as shown in Figure 1 to produce a lithographic printing member would result in a lesser amount of ink being applied to the substrate than if a lithographic screen were used with the normal exposure. This would be particularly noticeable at the shadow end of the tonal range from 50% to 100% and deep shadow printed overall would not be achieved.  It would also be noticeable at the high-light end of the range due to the dot size being too small.  A proof produced by the lithographic printing process from the screened film of Figure 1 would not provide a sufficiently accurate basis for assessing the final appearance of a print from the gravure printing process using that
screened film.

It is therefore necessary to increase the dot
size at the shadow end of the tonal range whilst still
leaving a balanced dot size separation in the middle and
lower tones as shown in Figure 3.

This result can be achieved by a film exposed
through a gravure screen.   To provide the increased dot
size the film may be overexposed through the continuous
tone and the gravure screen.   It is found in practice
that if the exposure is sufficient to close the dot in
the shadow area to leave only a narrow slightly
discernible gap therebetween at the 100% level as shown
in Figure 3 the minimum dot size is sufficiently
increased.

It is however possible that the necessary
overexposure will be such that the middle tones and
highlight areas will be overexposed and the dot formation
lack density in the core of the dots.   To overcome this
a general flash exposure of ten seconds can be made
without the continuous tone present to give a low
exposure followed by an exposure with the continuous tone
present of 1 1/4 minutes at maximum light.   If necessary
the exposure can be made through a rose coloured filter
to alter the contrast of the magenta gravure screen and
open the middle to upper tones and obtain a balanced
screen range in the screened image.   In the event that a
balanced screen range of the required values is not
thereby achieved the film when developed can be placed
over a further unexposed film with a clear film spacer
therebetween and a general maximum exposure given.   The
spacer holds the emulsion on the developed negative film
away from the unexposed film thus allowing a spread of

Z.416

0109183

light that increases the dot size required in the high-light and closes the dot wall in the shadows to an acceptable 95% level for proofing leaving a balanced dot size separation over the entire tonal range.

When developed the film provides a screened image exhibiting the characteristics of Figure 3 in the different parts of the tonal range and a proof print taken therefrom by the lithographic printing process exhibits the characteristics of a gravure print.

Z.416 EPO

0109183

C L A I M S

1.   A lithographic printing member characterised in the tonal range of the subject at the shadow end of the range in which the dots are 50% or more of the area comprises a plurality of discrete dots.

2.   A lithographic printing member according to Claim 1 characterised in that the dots at the 100% shadow end of the tonal range are separated by narrow slightly discernible gaps.

3.   A lithographic printing member acording to Claim 1 characterised in that these have at least 3,600 dots per $cm^2$.

4.   A method of producing a lithographic printing member comprising producing a continuous tone photographic image of the subject to be reproduced, and preparing a screened image for transfer to a lithographic printing member characterised in that the film is exposed to the continuous tone through a gravure screen to reproduce the varying tones of the subject in a pattern of discrete dots throughout the tonal range.

5.   A method according to Claim 4 characterised in that the film is exposed to give a dot size at the shadow end of the tonal range having a narrow slightly discernible gap therebetween.

6.   A method according to Claim 4 or Claim 5 characterised in that an additional exposure is effected by a flash exposure without the continuous tone present.

Z.416 EPO
0109183

7.   A method according to Claim 6 characterised in that the film is exposed with the continuous tone present using a rose coloured filter.

8.   A method according to any one of Claims 4 to 7 characterised in that the film is developed and a further film exposed thereto with a clear spacer therebetween.

100%

75%

50%

20-25%

*Fig.1.*

*Fig.2.*

*Fig.3.*